# EUROPEAN PATENT SPECIFICATION

(11) **EP 4 299 788 B1**
(45) Date of publication and mention of the grant of the patent: **30.07.2025**
(21) Application number: 23179870.3
(22) Date of filing: 16.06.2023
(51) Int. Cl.: C23C 16/44, C23C 16/455, C23C 16/52, C23C 16/54

(54) **CONTINUOUS ATMOSPHERIC PRESSURE CVD TOW COATER PROCESS WITH IN-SITU AIR LEAK MONITORING**
KONTINUIERLICHES CVD-TOW-BESCHICHTUNGSVERFAHREN UNTER ATMOSPHÄRENDRUCK UND IN-SITU-LUFTLECKÜBERWACHUNG
PROCÉDÉ DE REVÊTEMENT DE CÂBLE PAR CVD À PRESSION ATMOSPHÉRIQUE CONTINUE AVEC SURVEILLANCE IN SITU DE FUITE D'AIR

(30) Priority: 17.06.2022 US 202217843128
(43) Date of publication of application: 03.01.2024
(73) Proprietor: RTX Corporation, Farmington, CT 06032 (US)
(72) Inventor: SHE, Ying, Rocky Hill, 06067 (US); HOLOWCZAK, John E., South Windsor, 06074 (US); WALKER, John J., Vernon Rockville, 06066-4497 (US); GRONDA, Steven W., Feeding Hills, 01030 (US)
(74) Representative: Dehns

(56) References cited:
- US-A- 4 485 125
- US-A- 5 364 660
- US-A1- 2004 016 401
- US-A1- 2015 293 031

## Description

### BACKGROUND

The present disclosure relates to the continuous chemical vapor deposition coating of fiber tows.

A typical process to perform boron nitride (BN) interphase coatings on silicon carbide (SiC) fiber tows is through chemical vapor deposition (CVD) via either a continuous tow coating or batch process. US 5,364,660 discloses the continuous atmospheric pressure CVD coating of fibers in which a single tow or multiple tows are pulled through a cylindrical BN CVD reactor, where reactants are fed into the reactor either via co-feed or counter-feed mode with respect to the tow travel direction, achieving the interphase coatings on the tows. This process is known as an open CVD process, wherein the tow entrance and exit are open to ambient atmosphere. Exhaust from the CVD process can exit to the hood where the tow coater is located. Therefore, this process may generate potential environmental risk and may not meet current environmental, health, and safety (EH&S) standards.

US2004/0016401 discloses a reel to reel coating system for forming a superconducting wire on a tape substrate.

The use of probes to detect marker gas is known in the context of vapor deposition coating, e.g from US2015/0293031 and US4,485,125.

One potential solution to overcome this issue is to add an effluent outlet at the end of the tow coater and to pull a slightly low pressure inside the tow coater through the outlet by a vacuum pump to direct the effluent to a scrubber to neutralize the exhaust. Thus, with this approach, the pressure in the coater is less than the surrounding ambient pressure (P_{coater}<P_{amb}). This creates a different problem, however, in that the slight difference in pressure between the inside of the tow coater and the ambient atmosphere can pull ambient air into the tow coater through the tow entrance and/or exit, thus leading to an unintended oxygen content in the BN coatings, which is undesirable.

### SUMMARY

The invention provides a system for chemical vapor deposition as defined in claim 1. Particular embodiments of this system are defined in claims 2-8.

The invention further provides a method for chemical vapor deposition coating of fiber tows as defined in claim 9. Particular embodiments of this method are defined in claims 10-15.

In one disclosed configuration, a system for chemical vapor deposition coating of fiber tows, comprises a coater comprising a housing having a tow entrance and a tow exit and defining an interior space, the coater further comprising a process gas inlet and a process gas outlet; at least one of an entrance side marker gas inlet at the tow entrance and an exit side marker gas inlet at the tow exit; at least one of an entrance side detection probe upstream of the entrance side marker gas inlet, and an exit side detection probe downstream of the exit side marker gas inlet, the at least one entrance side detection probe and exit side detection probe being configured to detect marker gas.

In one non-limiting configuration, the system further comprises a pump communicated with the interior space of the coater whereby operation of the pump can be adjusted to adjust pressure in the interior space.

In a further non-limiting configuration, the system further comprises a take-off spool for feeding fiber tow to the tow entrance, and a take-up spool for receiving coated fiber tow from the tow exit.

In a still further non-limiting configuration, the system further comprises a source of marker gas communicated with the at least one entrance side marker gas inlet and exit side marker gas inlet.

In another non-limiting configuration, the source of marker gas comprises a source of an inert carrier gas containing a detectable fraction of detectible gas.

In still another non-limiting configuration, the source of marker gas comprises a source of nitrogen gas dosed with helium.

In a further non-limiting configuration, the at least one detection probe comprises a probe configured to detect helium.

In a still further non-limiting configuration, the system further comprises a control unit configured to receive input from the at least one detection probe and, upon receiving input indicating no marker gas detected, configured to operate the coater at a higher pressure in the interior space.

In another non-limiting configuration, the system further comprises a control unit configured to receive input from the at least one detection probe and, upon receiving input indicating no marker gas detected, configured to change operation of the pump to operate the coater at a higher pressure in the interior space.

In still another non-limiting configuration, the system comprises both of the entrance side marker gas inlet and the exit side marker gas inlet, and both of the entrance side marker gas detection probe and the exit side marker gas detection probe.

In another disclosed configuration, a method for chemical vapor deposition coating of fiber tows, comprises feeding a fiber tow to a tow entrance of a coater comprising a housing defining an interior space; feeding a chemical vapor deposition process gas to the coater at a process gas inlet such that fiber tow in the coater is coated to produce coated fiber tow; removing coated fiber tow from a tow exit of the coater; feeding a marker gas to at least one of an entrance side marker gas inlet at the tow entrance and an exit side marker gas inlet at the tow exit; and monitoring at least one of upstream of the entrance side marker gas inlet, and downstream of the exit side marker gas inlet, for presence of marker gas.

In another non-limiting configuration, the method further comprises adjusting pressure in the coater when the monitoring step does not detect marker gas.

In still another non-limiting configuration, the monitoring step comprises positioning at least one marker gas detection probe in the at least one of upstream of the entrance side marker gas inlet and downstream of the exit side marker gas inlet; and further comprising feeding output from the at least one marker gas detection probe to a control unit configured to operate the coater at a higher pressure when the output indicates no detection of marker gas.

In a further non-limiting configuration, a pump is associated with the interior space of the coater, and the control unit is configured to change operation of the pump to operate the coater at a higher pressure.

In a still further non-limiting configuration, the marker gas comprises an inert carrier gas dosed with a detectable amount of marker gas.

In another non-limiting configuration, the carrier gas is nitrogen.

In still another non-limiting configuration, the marker gas is helium.

In a further non-limiting configuration, the method further comprises removing the process gas from the coater at a process gas outlet of the coater.

In a still further non-limiting configuration, the method further comprises feeding process gas from the process gas outlet to a scrubber.

In another non-limiting configuration, the step of feeding the chemical vapor deposition process gas to the coater is carried out such that pressure inside the coater (P_{coater}) is less than ambient pressure (P_{ambient}) outside the coater (P_{coater} < P_{ambient}).

The foregoing features and elements may be combined in various combinations without exclusivity, unless expressly indicated otherwise. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

Various features will become apparent to those skilled in the art from the following detailed description of the disclosed non-limiting embodiment. The drawings that accompany the detailed description can be briefly described as follows:
FIG. 1 illustrates components of a continuous process as disclosed herein.
FIG. 2 illustrates an enlarged portion of FIG. 1; and
FIG. 3 illustrates a flow chart in the form of block diagrams that schematically illustrate this aspect of the present disclosure.

### DETAILED DESCRIPTION

The present disclosure relates to coating fiber tows and applies broadly to continuous and batch processes. As discussed below, the present disclosure is particularly well suited to processes wherein the ends or other areas of the coater are open to ambient conditions, and therefore is particularly well suited to continuous fiber tow coating processes.

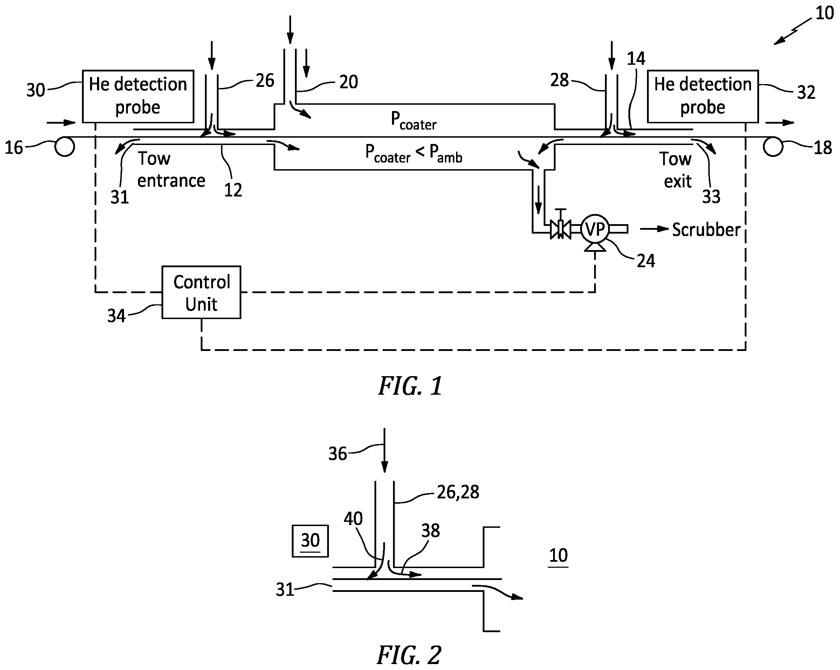

FIG. 1 shows a chemical vapor deposition coater 10 having a tow entrance 12 and a tow exit 14. Fiber tow can be fed from a take-off spool 16 to tow entrance 12, and coated fiber tow leaving the tow exit 14 can be taken up on a take-up spool 18. In FIG. 1, fiber tow passes through the open end at tow entrance 12 of coater 10, is coated within coater 10 to produce coated fiber tow, and coated fiber tow passes through the open end at tow exit 14.

Process gas for conducting the chemical vapor deposition (CVD) coating is fed to a process gas inlet 20, and can be removed from a process gas outlet 22, for example under operation of a vacuum pump 24.

An inlet side marker gas inlet 26 can be positioned at the tow entrance 12 of coater 10. Further, an exit side marker gas inlet 28 can be positioned at the tow exit 14 of coater 10.

An inlet side detection probe 30 (or entrance side detection probe) can be positioned upstream of inlet side marker gas inlet 26, and an exit side detection probe 32 can be positioned downstream of exit side marker gas inlet 28. Upstream and downstream as used with respect to the positioning of probes 30, 32 is with respect to the intended direction of flow at tow entrance 12 and tow exit 14. In the non-limiting configuration of FIG. 1, the upstream positioning of inlet side detection probe 30 means that probe 30 is positioned away from coater 10 with respect to marker gas inlet 26. In a further non-limiting configuration, probe 30 (See also FIG. 2) can be positioned at an inlet 31 of tow entrance 12. In this configuration, tow entrance 12 can be an elongated member sized sufficiently to accept incoming tow. Entrance 12 can be tubular, or have other cross-sectional shape to accept the entering tow to be coated. In this regard, while it is possible to coat a single tow as schematically illustrated, it should be appreciated that tow entrance 12 and reactor 10 can be configured to process numerous strands of tow in parallel as desired. Positioning of probe 30 at inlet 31 to tow entrance 12 helps to make sure that any marker gas detected at probe 30 is flowing sufficiently away from the reactor, rather than just being detected as part of a possible eddying of flow around marker gas inlet 26.

Further, the downstream positioning of the exit side detection probe 32 means that probe 32 is positioned away from coater 10 with respect to marker gas inlet 28. In this regard, and in similar manner to the inlet side, probe 32 can be positioned near an outlet 33 of tow exit 14. In this configuration, tow exit 14 can be an elongated member sized sufficiently to accept exiting coated tow. Exit 12 can also be tubular, or can have other cross-sectional shape to accept the exiting coated tow. In this regard, while it is possible to coat a single tow as schematically illustrated, it should be appreciated that tow entrance 12 and reactor 10 can be configured to process numerous strands of tow in parallel as desired. Positioning of probe 32 at outlet 33 from tow exit 14 helps to make sure that any marker gas detected at probe 32 is flowing sufficiently away from the reactor, rather than just being detected as part of a possible eddying of flow around marker gas inlet 28.

In the configuration described above, the marker gas detection probes 30, 32 detect for marker gas, and when they do detect marker gas, this is a good indication that flow from marker gas inlets 26, 28 is flowing away from the reactor as desired.

In an alternative configuration, probes 30, 32 could be positioned between marker gas inlets 26, 28 and the reactor 10. In this configuration, detection by the probes 30, 32 of no marker gas would be a favorable indication that no flow was traveling from the marker gas inlets 26, 28 toward the reactor 10. Thus, in this configuration, the marker gas would be used to allow confirmation that no air with accompanying marker gas is flowing from inlets 26, 28 toward reactor 10.

A control unit 34 can be provided and communicated with probes 30, 32 as well as, in this non-limiting configuration, pump 24. Control unit comprises or has access to storage to store control software configured to receive input from probes 30, 32. Further, control unit 34 is configured with this software to change operation of the coating process, for example by changing operation of pump 24, when no marker gas is detected by either or both of probes 30, 32 in which case it can be deduced that fluid or gas flow in the entrance 12 and/or exit 14 is flowing in the wrong direction and oxygen can be entering the coater 10. In such an event, pump 24 can be operated to increase pressure in the coater sufficiently that flow changes to the intended direction, and marker gas is detected at probes 30, 32. In the non-illustrated embodiment wherein the sensors are positioned toward the coater from the marker gas inlets 26, 28, these steps can be taken when marker gas is detected.

Ideally, coater 10 is operated with a slight vacuum with respect to ambient conditions surrounding the coater. This helps to keep process gases from escaping into the surrounding area and creating hazardous conditions. Further ideally, and as mentioned above, it is desirable to not have ambient air enter the coater, as this creates undesirable oxygen levels in the coating.

The positioning of marker gas inlets 26, 28 and probes 30, 32 allows detection of the flow conditions at the tow entrance 12 and tow exit 14. If probes 30, 32 detect marker gas, this means that the marker gas flow from inlets 26, 28 is at least partially moving away from the coater, and therefore that ambient air is not leaking into the coater. If, on the other hand, either or both probes 30, 32 do not detect the presence of marker gas, this means that the marker gas is flowing entirely toward the coater, and therefore that it is likely that some ambient air is also flowing in this direction. When this is the case, an increase in the pressure within the coater can help to restore flow conditions as desired and keep ambient air from leaking into the coater. In such a case, the process parameters such as tow coater pressure or nitrogen purge flow needs to be adjusted to assure that some nitrogen purge gas or marker gas is coming out of the tow entrance or exit based on the He detection system. Thus, when either or both of probes 30, 32 detects no marker gas, operation of vacuum pump 24 can be modified, or some other steps taken, to mildly increase pressure within the coater. Control unit 34 can be programmed and configured to operate in this manner.

The marker gas can be entirely a gas that can be detected by probes 30, 32, or can be a carrier gas doped with a marker gas fraction that can be detected by probes 30, 32. In one non-limiting configuration, marker gas can be a nitrogen carrier gas doped with helium. In this regard, a concentration of helium in the carrier gas can be between about 1 ppm and about 1000 ppm, and these limits can be selected to be reliably detected while minimizing the use of potentially costly helium. In both cases, the gases used are inert with respect to the coating process to limit impact on the composition of the coating. In one non-limiting configuration, the marker gas can be any gas that would be specific to the gas fed to inlets 26, 28, and that can be detected by a sensor. In one non-limiting configuration, this marker gas is helium, and the sensors are sensors configured to detect small concentrations of helium. Other configurations are possible within the broad scope of the disclosure.

The marker gas is referred to herein in places as being a purge gas. This is so because the gas can be introduced to the marker gas inlets at a flow rate and pressure sufficient to help keep ambient air away from the open ends of the coater. In this regard, marker gas can suitably be fed to the marker gas inlets at a flow rate of between 0.1 standard liter per minute (SLM) and 10 SLM and at a pressure of between 14.7 psi and 15.7 psi (101 kPa to 108 kPa) (or 0.1 to 10 L per minute at a pressure of 100 kPa and a temperature of 0 °C).

Typical fiber tow to be coated in this process can be silicon carbide fiber tows, for example. Other suitable fiber tows include carbon (C), silicon oxycarbide (SiOC), silicon nitride (Si₃N₄), silicon carbonitride (SiCN), hafnium carbide (HfC), tantalum carbide (TaC), silicon borocarbonitride (SiBCN), and silicon aluminum carbon nitride (SiAlCN), and alumina (Al₂O₃).

Typical process gas for use in CVD coating of fiber tow as disclosed herein can be process gas selected to deposit boron nitride coatings on the fiber tow. These gasses include, without limitation, boron trichloride (BCl₃) and ammonia (NH₃) mixed with inert gas such as nitrogen(N₂), hydrogen(H₂), argon (Ar), or mixtures thereof .

The relative pressures with respect to ambient and the coater can be, for example, 14.7 psi (101 kPa) at room temperature. Inside coater 10, this pressure can be kept slightly lower, for example between 12.7 psi (87.6 kPa) and 14.7 psi (101 kPa), to prevent escape of process gas out of the coater. Temperature within the coater will be between 900°C and 1500°C.

FIG. 2 is an enlarged portion of FIG. 1 and shows in greater scale one of the marker gas inlets 26, 28 and the possible directions in which the marker gas can flow. As shown, marker gas (schematically illustrated at arrow 36) can be introduced into marker gas inlet 26, 28 and, when this gas flow reaches tow entrance 12 and/or tow exit 14, it can flow in either or both directions shown, that is, in a direction 38 toward coater 10, and/or in a direction 40 that is away from coater 10. If flow is in direction 38 only, then no marker gas will reach probe 30-32, which will then signal the possibility that air is leaking into coater 10. If any flow of marker gas is detected in direction 40, then this is conclusive evidence that marker gas is flowing out of the coater 10, and therefore that ambient air is not leaking into coater 10. The direction of flow of marker gas introduced into inlet 26, 28, can be determined by a combination of the relationship between pressure in the coater and surrounding ambient pressure. In this regard, this relationship can be adjusted by adjusting the pressure in the coater. In addition, the relationship can be determined by a volume of flow through inlets 26, 28.

It should be appreciated that in addition to the marker gas sensors as disclosed herein, one or more oxygen sensors can be added to the system to supplement the ability to monitor for oxygen in the reactor and in some instances be able to reduce the number of relatively more expensive helium sensors that are needed.

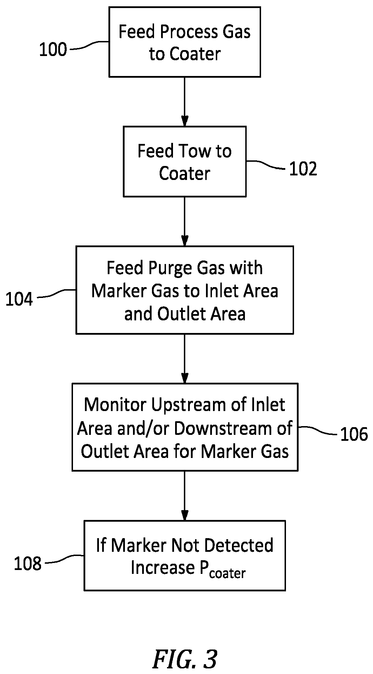

FIG. 3 schematically illustrates a process in accordance with the present disclosure which can be used to provide in situ monitoring of the inlet and outlet of a coater 10 as disclosed herein. As shown, the process can start with the feeding of process gas into a coater as shown at step 100. Once the process gas is in place, the coating process can be started by feeding the fiber tow to coater 10 as shown in step 102. Coater 10 can be kept at process conditions suitable to have the process gasses make a deposit of a process gas materials on the fiber tow, thereby coating such fiber tow materials with a coating derived from the process gasses.

While the coating is conducted, a marker gas can be fed to inlets 26, 28 as shown in step 104. As discussed above, this marker gas reaches entrance 12 and exit 14, and can flow in either or both of away from coater 10, and toward coater 10. This step is schematically illustrated at 104.

Next, in step 106, probes 30, 32 can be used to monitor upstream of the inlet 26 and downstream of the inlet 28, for example at inlet 31 and outlet 33, for the presence of marker gas. As long as marker gas is detected, the process can proceed in a normal and steady state condition. However, the absence of marker gas at the monitored areas of inlets 26 and 28, for example at inlet 31 and outlet 33, means that the marker gas is flowing entirely toward the coater, and therefore it is possible or likely that ambient air is also flowing toward the coater.

If this is the case, then in step 108, steps can be taken to increase pressure within the coater. This can be done by increasing purge flow rate of the marker gas if desired, or by decreasing the pressure within the coater for example by increasing operation of vacuum pump 24, or the like.

The system and method disclosed herein offer a continuous atmospheric pressure CVD tow coater process with in-situ air leak monitoring using a He detection system. The proposed process can improve the performance and lifetime of ceramic matrix composite (CMC) materials because it can reduce detrimental oxygen content in the interface coatings by avoiding ambient air leaking into the tow coater.

The use of the terms "a" and "an" and "the" and similar references in the context of description (especially in the context of the following claims) are to be construed to cover both the singular and the plural, unless otherwise indicated herein or specifically contradicted by context. The modifier "about" used in connection with a quantity is inclusive of the stated value and has the meaning dictated by the context (e.g., it includes the degree of error associated with measurement of the particular quantity). All ranges disclosed herein are inclusive of the endpoints, and the endpoints are independently combinable with each other. It should be appreciated that relative positional terms such as "forward," "aft," "upper," "lower," "above," "below," and the like are with reference to the normal operational attitude of the vehicle and should not be considered otherwise limiting.

It should be appreciated that like reference numerals identify corresponding or similar elements throughout the several drawings. It should also be appreciated that although a particular component arrangement is disclosed in the illustrated embodiment, other arrangements will benefit from the subject matter disclosed herein.

Although particular step sequences are shown, described, and claimed, it should be understood that steps may be performed in any order, separated or combined unless otherwise indicated and will still benefit from the present disclosure.

The foregoing description is exemplary rather than defined by the limitations within. Various non-limiting embodiments are disclosed herein, however, one of ordinary skill in the art would recognize that various modifications and variations in light of the above teachings will fall within the scope of the appended claims. It is therefore to be understood that within the scope of the appended claims, the disclosure may be practiced other than as specifically described. For that reason the appended claims should be studied to determine true scope and content.

## Claims

1. A system for chemical vapor deposition coating of fiber tows, comprising:
a coater (10) comprising a housing having a tow entrance (12) and a tow exit (14) and defining an interior space, the coater (10) further comprising a process gas inlet (20) and a process gas outlet (22);
at least one of an entrance side marker gas inlet (26) at the tow entrance (12) and an exit side marker gas inlet (28) at the tow exit (14);
at least one of an entrance side detection probe (30) upstream of the entrance side marker gas inlet (26), and an exit side detection probe (32) downstream of the exit side marker gas inlet (28), the at least one entrance side detection probe (30) and exit side detection probe (32) being configured to detect marker gas.

2. The system of claim 1, further comprising a pump (24) communicated with the interior space of the coater (10) whereby operation of the pump (24) can be adjusted to adjust pressure in the interior space.

3. The system of claim 1 or 2, further comprising a take-off spool (16) for feeding fiber tow to the tow entrance (12), and a take-up spool (18) for receiving coated fiber tow from the tow exit (14).

4. The system of any preceding claim, further comprising a source of marker gas communicated with the at least one entrance side marker gas inlet (26) and exit side marker gas inlet (28), wherein the source of marker gas optionally comprises a source of an inert carrier gas containing a detectable fraction of detectible gas.

5. The system of claim 4, wherein the source of marker gas comprises a source of nitrogen gas dosed with helium, wherein the at least one entrance side detection probe (30) and/or exit side detection probe (32) optionally comprises a probe (30; 32) configured to detect helium.

6. The system of any preceding claim, further comprising a control unit (34) configured to receive input from at least one of the at least one entrance side detection probe (30) and of the exit side detection probe (32) and, upon receiving input indicating no marker gas detected, configured to operate the coater (10) at a higher pressure in the interior space.

7. The system of claim 2 or any of claims 3 to 5 as dependent on claim 2, further comprising a control unit (34) configured to receive input from at least one of the at least one entrance side detection probe (30) and of the exit side detection probe (32) and, upon receiving input indicating no marker gas detected, configured to change operation of the pump (24) to operate the coater (10) at a higher pressure in the interior space.

8. The system of any preceding claim, wherein the system comprises both of the entrance side marker gas inlet (26) and the exit side marker gas inlet (28), and both of the entrance side marker gas detection probe (30) and the exit side marker gas detection probe (32).

9. A method for chemical vapor deposition coating of fiber tows, comprising:
feeding a fiber tow to a tow entrance (12) of a coater (10) comprising a housing defining an interior space;
feeding a chemical vapor deposition process gas to the coater (10) at a process gas inlet (20) such that fiber tow in the coater (10) is coated to produce coated fiber tow;
removing coated fiber tow from a tow exit (14) of the coater (10);
feeding a marker gas to at least one of an entrance side marker gas inlet (26) at the tow entrance (12) and an exit side marker gas inlet (28) at the tow exit (14); and
monitoring at least one of upstream of the entrance side marker gas inlet (26), and downstream of the exit side marker gas inlet (28), for presence of marker gas.

10. The method of claim 9, further comprising adjusting pressure in the coater (10) when the monitoring step does not detect marker gas.

11. The method of claim 9 or 10, wherein the monitoring step comprises positioning at least one marker gas detection probe (30; 32) in the at least one of upstream of the entrance side marker gas inlet (26) and downstream of the exit side marker gas inlet (28); and further comprising feeding output from the at least one marker gas detection probe (30; 32) to a control unit (34) configured to operate the coater (10) at a higher pressure when the output indicates no detection of marker gas.

12. The method of claim 11, further comprising a pump (24) associated with the interior space of the coater (10), wherein the control unit (34) is configured to change operation of the pump (24) to operate the coater (10) at a higher pressure.

13. The method of any of claims 9 to 12, wherein the marker gas comprises an inert carrier gas dosed with a detectable amount of marker gas, optionally wherein the carrier gas is nitrogen; and/or optionally wherein the marker gas is helium.

14. The method of any of claims 9 to 13, further comprising:
removing the process gas from the coater (10) at a process gas outlet (22) of the coater (10); and
optionally feeding process gas from the process gas outlet (22) to a scrubber.

15. The method of any of claims 9 to 14, wherein the step of feeding the chemical vapor deposition process gas to the coater (10) is carried out such that pressure inside the coater (10) (P_{coater}) is less than ambient pressure (P_{ambient}) outside the coater (10) (P_{coater} < P_{ambient}).

## Patentansprüche

1. System zur Beschichtung von Faserkabeln durch chemische Gasphasenabscheidung, umfassend:
einen Beschichter (10), der ein Gehäuse mit einem Kabeleingang (12) und einem Kabelausgang (14) umfasst und einen Innenraum definiert, wobei der Beschichter (10) ferner einen Prozessgaseinlass (20) und einen Prozessgasauslass (22) umfasst; mindestens einen von einem eingangsseitigen Markierungsgaseinlass (26) am Kabeleingang (12) und einem ausgangsseitigen Markierungsgaseinlass (28) am Kabelausgang (14) ;
mindestens eine von einer eingangsseitigen Detektionssonde (30) stromaufwärts des eingangsseitigen Markierungsgaseinlasses (26) und einer ausgangsseitigen Detektionssonde (32) stromabwärts des ausgangsseitigen Markierungsgaseinlasses (28), wobei die mindestens eine eingangsseitige Detektionssonde (30) und ausgangsseitige Detektionssonde (32) zum Detektieren von Markierungsgas konfiguriert sind.

2. System nach Anspruch 1, das ferner eine Pumpe (24) umfasst, die dem Innenraum des Beschichters (10) zugeordnet ist, wobei der Betrieb der Pumpe (24) angepasst werden kann, um den Druck im Innenraum anzupassen.

3. System nach Anspruch 1 oder 2, das ferner eine Abnahmespule (16) zum Zuführen von Faserkabel zum Kabeleingang (12) und eine Aufnahmespule (18) zum Aufnehmen von beschichtetem Faserkabel vom Kabelausgang (14) umfasst.

4. System nach einem der vorhergehenden Ansprüche, das ferner eine Markierungsgasquelle umfasst, die mit mindestens einem eingangsseitigen Markierungsgaseinlass (26) und einem ausgangsseitigen Markierungsgaseinlass (28) verbunden ist, wobei die Markierungsgasquelle wahlweise eine Quelle eines inerten Trägergases umfasst, das einen detektierbaren Anteil an detektierbarem Gas enthält.

5. System nach Anspruch 4, wobei die Markierungsgasquelle eine Quelle von mit Helium versetztem Stickstoffgas umfasst, wobei die mindestens eine eingangsseitige Detektionssonde (30) und/oder ausgangsseitige Detektionssonde (32) wahlweise eine Sonde (30; 32) umfasst, die zum Detektieren von Helium konfiguriert ist.

6. System nach einem der vorhergehenden Ansprüche, das ferner eine Steuereinheit (34) umfasst, die zum Empfangen von Eingangssignalen von mindestens einer der mindestens einen eingangsseitigen Detektionssonde (30) und der ausgangsseitigen Detektionssonde (32) konfiguriert ist und die, wenn sie Eingangssignale empfängt, die anzeigen, dass kein Markierungsgas erfasst wurde, zum Betreiben des Beschichters (10) bei einem höheren Druck im Innenraum konfiguriert ist.

7. System nach Anspruch 2 oder einem der Ansprüche 3 bis 5 in Abhängigkeit von Anspruch 2, das ferner eine Steuereinheit (34) umfasst, die zum Empfangen von Eingangssignalen von mindestens einer der mindestens einen eingangsseitigen Detektionssonde (30) und der ausgangsseitigen Detektionssonde (32) konfiguriert ist und die, wenn sie Eingangssignale empfängt, die anzeigen, dass kein Markierungsgas erfasst wurde, zum Ändern des Betriebs der Pumpe (24) konfiguriert ist, um den Beschichter (10) bei einem höheren Druck im Innenraum zu betreiben.

8. System nach einem der vorhergehenden Ansprüche, wobei das System sowohl den eingangsseitigen Markierungsgaseinlass (26) als auch den ausgangsseitigen Markierungsgaseinlass (28) und sowohl die eingangsseitige Markierungsgasdetektionssonde (30) als auch die ausgangsseitige Markierungsgasdetektionssonde (32) umfasst.

9. Verfahren zur Beschichtung von Faserkabeln durch chemische Gasphasenabscheidung, umfassend:
Zuführen eines Faserkabels zu einem Kabeleingang (12) eines Beschichters (10), der ein Gehäuse umfasst, das einen Innenraum definiert;
Zuführen eines Prozessgases für die chemische Gasphasenabscheidung in den Beschichter (10) an einem Prozessgaseinlass (20), so dass das Faserkabel im Beschichter (10) beschichtet wird, um ein beschichtetes Faserkabel zu erzeugen;
Entfernen des beschichteten Faserkabels aus einem Kabelausgang (14) des Beschichters (10);
Zuführen eines Markierungsgases zu mindestens einem von einem eingangsseitigen Markierungsgaseinlass (26) am Kabeleingang (12) und einem ausgangsseitigen Markierungsgaseinlass (28) am Kabelausgang (14); und
Überwachen des Vorhandenseins von Markierungsgas vor mindestens einem von einem eintrittsseitigen Markierungsgaseinlass (26) und hinter einem austrittsseitigen Markierungsgaseinlass (28).

10. Verfahren nach Anspruch 9, das ferner Anpassen des Drucks im Beschichter (10) umfasst, wenn der Überwachungsschritt kein Markierungsgas detektiert.

11. Verfahren nach Anspruch 9 oder 10, wobei der Überwachungsschritt Positionieren mindestens einer Markierungsgas-Detektionssonde (30; 32) in der mindestens einen Position von stromaufwärts des eingangsseitigen Markierungsgaseinlasses (26) und stromabwärts des ausgangsseitigen Markierungsgaseinlasses (28); und ferner Weiterleiten der Ausgabe von mindestens einer Markierungsgas-Detektionssonde (30; 32) an eine Steuereinheit (34), die dazu konfiguriert ist, den Beschichter (10) bei einem höheren Druck zu betreiben, wenn die Ausgabe keine Detektion von Markierungsgas anzeigt.

12. Verfahren nach Anspruch 11, das ferner eine Pumpe (24) umfasst, die mit dem Innenraum des Beschichters (10) verbunden ist, wobei die Steuereinheit (34) zum Ändern des Betriebs der Pumpe (24) konfiguriert ist, um den Beschichter (10) bei einem höheren Druck zu betreiben.

13. Verfahren nach einem der Ansprüche 9 bis 12, wobei das Markierungsgas ein inertes Trägergas umfasst, dem eine detektierbare Menge Markierungsgas zugesetzt ist, wobei das Trägergas wahlweise Stickstoff ist; und/oder wobei das Markierungsgas wahlweise Helium ist.

14. Verfahren nach einem der Ansprüche 9 bis 13, ferner umfassend:
Entfernen des Prozessgases aus dem Beschichter (10) an einem Prozessgasauslass (22) des Beschichters (10); und
wahlweise Zuführen von Prozessgas aus dem Prozessgasauslass (22) zu einem Wäscher.

15. Verfahren nach einem der Ansprüche 9 bis 14, wobei der Schritt des Zuführens des Prozessgases für die chemische Gasphasenabscheidung zum Beschichter (10) so ausgeführt wird, dass der Druck im Inneren des Beschichters (10) (P_{coater}) niedriger ist als der Umgebungsdruck (P_{ambient}) außerhalb des Beschichters (10) (P_{coater} < P_{ambient}).

## Revendications

1. Système de revêtement de câbles de fibres par dépôt chimique en phase vapeur, comprenant :
un dispositif de revêtement (10) comprenant un boîtier ayant une entrée de câble (12) et une sortie de câble (14) et définissant un espace intérieur, le dispositif de revêtement (10) comprenant également une entrée de gaz de processus (20) et une sortie de gaz de processus (22) ;
au moins l'une d'une entrée de gaz marqueur côté entrée (26) à l'entrée de câble (12) et d'une entrée de gaz marqueur côté sortie (28) à la sortie de câble (14) ;
au moins l'une d'une sonde de détection côté entrée (30) en amont de l'entrée de gaz marqueur côté entrée (26), et d'une sonde de détection côté sortie (32) en aval de l'entrée de gaz marqueur côté sortie (28), l'au moins une sonde de détection côté entrée (30) et une sonde de détection côté sortie (32) étant configurées pour détecter le gaz marqueur.

2. Système selon la revendication 1, comprenant également une pompe (24) en communication avec l'espace intérieur du dispositif de revêtement (10), moyennant quoi le fonctionnement de la pompe (24) peut être ajusté pour ajuster la pression dans l'espace intérieur.

3. Système selon la revendication 1 ou 2, comprenant également une bobine d'alimentation (16) pour alimenter en câble de fibres l'entrée de câble (12), et une bobine d'alimentation (18) pour recevoir un câble de fibres revêtu depuis la sortie de câble (14).

4. Système selon une quelconque revendication précédente, comprenant également une source de gaz marqueur en communication avec l'au moins une entrée de gaz marqueur côté entrée (26) et une entrée de gaz marqueur côté sortie (28), dans lequel la source de gaz marqueur comprend éventuellement une source d'un gaz porteur inerte contenant une fraction détectable de gaz détectable.

5. Système selon la revendication 4, dans lequel la source de gaz marqueur comprend une source d'azote gazeux dosée en hélium, dans lequel l'au moins une sonde de détection côté entrée (30) et/ou une sonde de détection côté sortie (32) comprennent éventuellement une sonde (30 ; 32) configurée pour détecter l'hélium.

6. Système selon une quelconque revendication précédente, comprenant également une unité de commande (34) configurée pour recevoir une entrée provenant d'au moins l'une de l'au moins une sonde de détection côté entrée (30) et de la sonde de détection côté sortie (32) et, lors de la réception d'une entrée indiquant qu'aucun gaz marqueur n'est détecté, configurées pour faire fonctionner le dispositif de revêtement (10) à une pression plus élevée dans l'espace intérieur.

7. Système selon la revendication 2 ou l'une quelconque des revendications 3 à 5 telles qu'elles dépendent de la revendication 2, comprenant également une unité de commande (34) configurée pour recevoir une entrée provenant d'au moins une de l'au moins une sonde de détection côté entrée (30) et de la sonde de détection côté sortie (32) et, lors de la réception d'une entrée indiquant qu'aucun gaz marqueur n'est détecté, configurées pour modifier le fonctionnement de la pompe (24) afin de faire fonctionner le dispositif de revêtement (10) à une pression plus élevée dans l'espace intérieur.

8. Système selon une quelconque revendication précédente, dans lequel le système comprend à la fois l'entrée de gaz marqueur côté entrée (26) et l'entrée de gaz marqueur côté sortie (28), et à la fois la sonde de détection de gaz marqueur côté entrée (30) et la sonde de détection de gaz marqueur côté sortie (32).

9. Procédé de revêtement de câbles de fibres par dépôt chimique en phase vapeur, comprenant :
l'alimentation d'un câble de fibres vers une entrée de câble (12) d'un dispositif de revêtement (10) comprenant un boîtier définissant un espace intérieur ;
l'alimentation d'un gaz de processus de dépôt chimique en phase vapeur dans le dispositif de revêtement (10) au niveau d'une entrée de gaz de processus (20) de sorte que le câble de fibres dans le dispositif de revêtement (10) est revêtu pour produire un câble de fibres revêtu ;
le retrait du câble de fibres revêtu d'une sortie de câble (14) du dispositif de revêtement (10) ;
l'alimentation d'un gaz marqueur d'au moins l'une d'une entrée de gaz marqueur côté entrée (26) à l'entrée de câble (12) et d'une entrée de gaz marqueur côté sortie (28) à la sortie de câble (14) ; et
la surveillance d'au moins l'un des éléments suivants : en amont de l'entrée de gaz marqueur côté entrée (26), et en aval de l'entrée de gaz marqueur côté sortie (28), pour détecter la présence de gaz marqueur.

10. Procédé selon la revendication 9, comprenant également l'ajustement de la pression dans le dispositif de revêtement (10) lorsque l'étape de surveillance ne détecte pas de gaz marqueur.

11. Procédé selon la revendication 9 ou 10, dans lequel l'étape de surveillance comprend le positionnement d'au moins une sonde de détection de gaz marqueur (30 ; 32) dans l'au moins un des éléments suivants : en amont de l'entrée de gaz marqueur côté entrée (26) et en aval de l'entrée de gaz marqueur côté sortie (28) ; et comprenant également l'alimentation de la sortie de l'au moins une sonde de détection de gaz marqueur (30 ; 32) à une unité de commande (34) configurée pour faire fonctionner le dispositif de revêtement (10) à une pression plus élevée lorsque la sortie n'indique aucune détection de gaz marqueur.

12. Procédé selon la revendication 11, comprenant également une pompe (24) associée à l'espace intérieur du dispositif de revêtement (10), dans lequel l'unité de commande (34) est configurée pour modifier le fonctionnement de la pompe (24) afin de faire fonctionner le dispositif de revêtement (10) à une pression plus élevée.

13. Procédé selon l'une quelconque des revendications 9 à 12, dans lequel le gaz marqueur comprend un gaz porteur inerte dosé avec une quantité détectable de gaz marqueur, éventuellement dans lequel le gaz porteur est de l'azote ; et/ou éventuellement dans lequel le gaz marqueur est de l'hélium.

14. Procédé selon l'une quelconque des revendications 9 à 13, comprenant également :
le retrait du gaz de processus du dispositif de revêtement (10) au niveau d'une sortie de gaz de processus (22) du dispositif de revêtement (10) ; et
l'alimentation éventuelle d'un épurateur en gaz de processus à partir de la sortie de gaz de processus (22).

15. Procédé selon l'une quelconque des revendications 9 à 14, dans lequel l'étape d'alimentation du dispositif de revêtement (10) en gaz de processus de dépôt chimique en phase vapeur est réalisée de sorte que la pression à l'intérieur du dispositif de revêtement (10) (P_{dispositif de revêtement}) est inférieure à la pression ambiante (P_{ambiante}) à l'extérieur du dispositif de revêtement (10) (P_{dispositif de revêtement} < P_{ambiante}).
